# EUROPEAN PATENT SPECIFICATION

(11) **EP 2 089 726 B1**
(45) Date of publication and mention of the grant of the patent: **13.09.2017**
(21) Application number: 07817946.2
(22) Date of filing: 11.10.2007
(51) Int. Cl.: G01R 22/06, G01R 21/133

(54) **ELECTRICITY METER WITH SWITCH MODE VOLTAGE SUPPLY**
STROMZÄHLER MIT SCHALTNETZTEIL
COMPTEUR ÉLECTRIQUE ÉQUIPÉ D'UNE ALIMENTATION À MODE DE COMMUTATION

(30) Priority: 07.11.2006 DK 200600285 U
(43) Date of publication of application: 19.08.2009
(73) Proprietor: KAMSTRUP A/S, 8660 Skanderborg (DK)
(72) Inventor: HANSEN, Gorm Bass, 8722 Hedensted (DK)
(74) Representative: Plougmann Vingtoft a/s
(86) International application number: PCT/DK2007/050148
(87) International publication number: WO 2008/055507

(56) References cited:
- DE-A1- 2 923 341
- GB-A- 2 295 682
- US-A- 4 351 028
- US-A1- 2005 017 751

## Description

### FIELD OF THE INVENTION

The invention relates to an electricity meter, particularly an electricity meter for measuring electricity consumption in polyphasic electricity systems, including high-precision meters for measuring electricity consumption of a user in an electricity supply network in connection with payment to the electricity provider for consumed electric energy.

### BACKGROUND OF THE INVENTION

Meters of prior art for measuring electric energy such as that disclosed in DE 29 23 341 A1 contain a measuring circuit, one for each phase, determining the electric power based on a detection of a voltage and a current, the current being detected as a voltage across a known shunt resistor. These measuring circuits are often integrated measuring circuits being supplied with low voltage and processing low voltage signals. Current is measured as the voltage over a shunt resistor in relation to the voltage on a phase. Thus, the measuring circuit may be placed directly on the phase potential or on a different potential, and the measure voltage must therefore be transferred through a galvanic separation. In polyphasic electricity meters the phase potentials must be kept separate, and it is therefore necessary to galvanically separate the measurements or the supply to the measuring circuits.

Normally, such polyphasic meters include a transformer transforming the supply voltage (often 50 Hz) down to a voltage level suitable for supplying a measuring circuit for each phase, a meter unit calculating the total electricity consumption, and for example a radio module for remote reading and possibly modules with additional functions attached to the electricity meter.

Often, common iron core transformers are used to supply low voltage to the measuring circuits. This may be low voltage for the supply of the measuring circuits, but the transformer may also be used to transfer measuring voltage between galvanically separated potentials. In order to be able to function in these contexts, transformers having high induction are used so as not to impose load, and at the same time the transformer must have a good coupling to ensure a stable ratio between input and output voltage. The induction is proportional to the permeability of the iron, and if the iron is saturated, permeability is considerably reduced. As the transformer is to transform the quite low frequency 50 Hz of the supply voltage, it is vulnerable to external magnetic influence, which will change the permeability and thereby damage the intended properties of the transformer. This occurs for example in connection with an attempt to bypass the electricity measurement by placing a strong magnet close to the meter. This significantly changes the properties of the iron core in the transformer, the result being that it is possible to influence the current measurement and thus the total electricity measurement in the direction of a detected incorrect electricity consumption.

### SUMMARY OF THE INVENTION

Based on the above, it is therefore desirable to provide an electricity meter for measuring electricity consumption in polyphasic electricity networks, in which the electricity meter is immune or approximately immune to external magnetic influence.

This and other objects are met with an electricity meter for measuring electricity consumption in an electricity supply network with one or more phases, wherein the electricity meter comprises
- a measuring circuit for each of the one or more phases for measuring the electric energy for each phase
- a voltage supply which is fed with electricity from the electricity supply network, wherein the voltage supply comprises
   - a switch mode circuit, and
   - a transformer with a primary winding connected to the output of the switch mode circuit, wherein the transformer comprises separate galvanically separated secondary windings for voltage supply of the respective separate measuring circuits for each phase.

One of the advantages of such an electricity meter is that it is possible, by appropriate dimensioning of the switch mode voltage supply, that the transformer can suitably feed the measuring circuits even if the properties of the transformer core are influenced significantly by a strong magnet. This is primarily due to the fact that the transformer is supplied with voltage from switch mode voltage supply which preferably operates with a switch frequency that is significantly higher than the 50 Hz of the electricity supply network, e.g. 10 kHz or 100 kHz or possibly higher. This significantly reduces the requirements for induction in the transformer, the result being that the electricity is much more immune to external influence by a strong magnet. For example, the transformer may have a ferrite core or may not have a core at all.

In preferred embodiments the switch mode circuit is furthermore provided with feedback on the voltage on a secondary winding on the transformer, such that the switch mode circuit is able to regulate the energy supply to the primary winding on the transformer in order to maintain a constant voltage on the secondary winding. Such feedback from the secondary side of the transformer will have the effect that changes in the transformer, at least within certain limits, will not influence the output voltage.

In preferred embodiments the transformer is used solely as voltage supply to the measuring circuits for each phase, but not as a transformer for measuring voltage for each phase. This has the effect that the measuring result can only be externally influenced if the properties of the transformer are changed to such a degree that the voltage supply cannot supply sufficient voltage for the measuring circuits to be able to work. The probability of this happening is considerably reduced with the use of the switch mode voltage supply combined with a low induction transformer and for example feedback as mentioned above.

Because there are galvanically separated secondary windings for voltage supply to each of the measuring circuits for each of the phases, the measuring circuits can use the shunt resistor principle for measuring current consumption.

In preferred embodiments, the transformer further comprises at least one separate galvanically separated secondary winding for the voltage supply to additional circuits in relation to the electricity meter, e.g. a calculation circuit for receiving energy consumption data from each of the separate measuring circuits and calculation of a total energy consumption as a sum thereof. Additional circuits may also comprise a radio module for wireless communication of electricity consumption data, various circuits for user interface such as display etc. Calculating circuits and additional circuits may preferably be supplied by one common secondary winding.

In preferred embodiments of the electricity meter it has two measuring circuits on each of two phases, or three measuring circuits on each of three phases.

In polyphasic electricity meters it is preferred that the voltage supply is connected to all phases such that the voltage supply, including the switch mode circuit, is supplied with voltage when there is voltage on just one of the phases. This ensures that the calculating circuit is supplied with voltage when there is voltage on just one of the phases.

The electricity meter according to the invention is suitable for all types of high precision measuring of electricity consumption, i.e. for use at private consumers or companies which are supplied with electricity from one electricity provider via an electricity supply network.

### BRIEF DESCRIPTION OF THE FIGURES

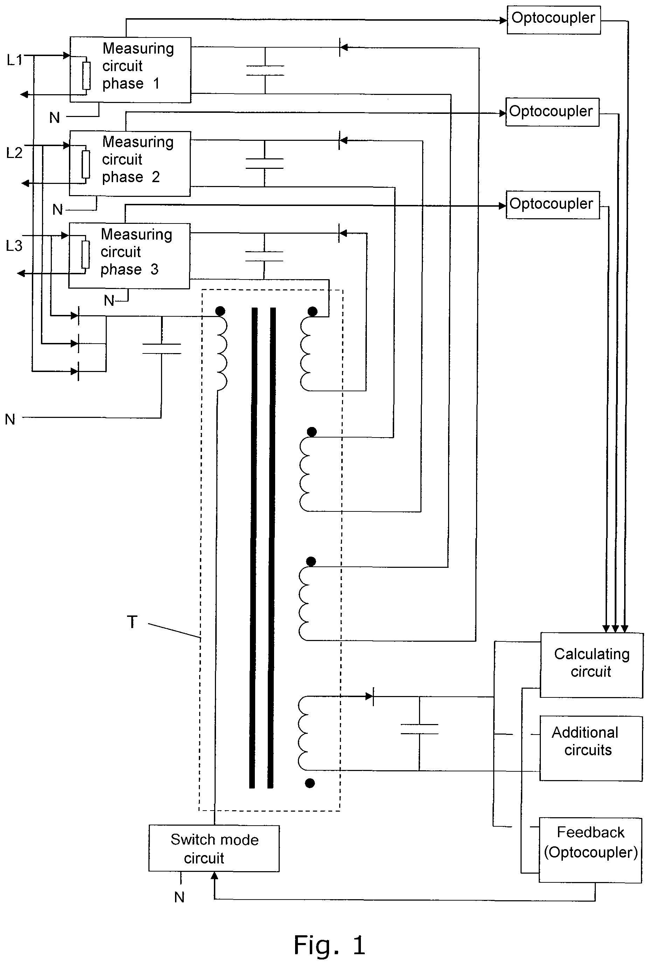

Below, an embodiment of the invention is described with reference to figure 1 which shows a survey diagram of a three phase electricity meter according to the invention.

### DETAILED DESCRIPTION OF THE FIGURES

Figure 1 shows an electricity meter for measuring the total electricity consumption on the three phases L1, L2 and L3. N denotes "neutral". Separate measuring circuits for each of the phases L1, L2, L3 measure and calculate an energy consumption for each phase and communicate this result, via an optocoupler, to a calculation circuit which sums up the consumption results for each of the phases L1, L2, L3 and thus calculates a total energy consumption.

As can be seen, in the shown embodiment there are additional circuits supplied by the same secondary winding as the calculating circuit. The additional circuits may be a communication module, e.g. a radio module coupled to the calculating circuit in such a way that the total energy, and any other data, may be sent wirelessly to corresponding meters coupled in a wireless network, or directly to a reading central.

The separate measuring circuits for each of the three phases L1, L2, L3 are directly coupled to the phases L1, L2, L3 in such a way that they are able to measure the voltage of each of the phases L1, L2, L3. As indicated on figure 1, the measuring circuits determine the current drawn on each of the phases based on the shunt resistor principle. They are therefore coupled directly to the voltage potential for each phase and must therefore be supplied with voltage separately with galvanic separation. As can be seen in figure 1, the transformer T therefore has separate secondary windings which are galvanically separated from each other for voltage supply of each of the measuring circuits.

Calculating circuits, additional circuits and feedback (optocoupler) for the switch mode circuit in the switch mode voltage supply, are furthermore supplied with voltage from an additional secondary winding on the transformer T, as this secondary winding is galvanically separated from the secondary windings for the supply to the measuring circuits.

The primary winding of the transformer T is charged with energy from a coupled switch mode circuit operating with a switch frequency of preferably 100 kHz or more. As may be seen, the switch mode circuit is connected to the primary winding of the transformer, and the primary winding is connected to the phases L1, L2, L3 via diodes in such a way that there will be supply voltage to switch mode circuits and calculating circuits when there is just voltage on one of the three phases L1, L2, L3.

A feedback circuit is connected to the same secondary winding as the calculating circuit and any additional circuits. The feedback circuit is connected to the switch mode circuit and provides the switch mode circuit with information on the voltage level feeding the calculating circuit. The switch mode circuit then regulates its energy supply to the primary winding based on this information. It has been decided to let the switch mode circuit regulate the energy supply to the primary winding based on the secondary winding feeding the calculating circuit and any additional circuits, as these circuits have the highest consumption, whereas the measuring circuits have a low consumption.

The switch mode circuit is preferably supplied with voltage by the primary winding via an integrated high voltage regulator, alternatively through an extra secondary winding on the transformer.

It is preferred that the transformer T has a ferrite core combined with a large air gap such that its primary induction is maximally 20 times larger with the core being mounted than without the core being mounted, preferably the primary induction is 5-15 times larger with the core being mounted than without the core being mounted. Furthermore, it is preferred to dimension the voltage supply so as to supply sufficient power to the coupled circuits, i.e. measuring circuits, calculating circuits and any other circuits, without core in the transformer T. In combination with the described feedback coupling of the switch mode circuit, this means that the electricity meter can work almost without external influence by a strong magnetic field.

## Claims

1. An electricity meter for measuring electricity consumption in an electricity supply network with one or more phases (L1,L2,L3), in which the electricity meter comprises
- a measuring circuit for each of the one or more phases for measuring electric energy for each phase,
- a voltage supply being supplied with electricity from the electricity supply network, the voltage supply comprising
- a switch mode circuit, and
- a transformer (T) with a primary winding connected to the output of the switch mode circuit, wherein the transformer comprises separate galvanically separated secondary windings for voltage supply of the respective separate measuring circuits for each phase,
**characterised in that** the transformer is supplied with voltage from the switch mode circuit which operates with a switch frequency that is significantly higher than that of the electricity supply network such that the voltage supply can supply sufficient power to drive the measuring and calculating circuits without a core in the transformer.

2. An electricity meter according to claim 1, in which the transformer further comprises at least one separate galvanically separated secondary winding for voltage supply of additional circuits in relation to the electricity meter.

3. An electricity meter according to claim 2, in which the additional circuits comprise a calculating circuit for receiving energy consumption data for each of the separate measuring circuits and for calculating a total energy consumption as a sum thereof.

4. Electricity meter according to claim 3, in which the switch mode circuit is provided with feedback on the voltage of the at least one separate secondary winding for voltage supply of the calculating circuit, and in which the switch mode circuit uses this feedback for the regulation of energy supply to the primary winding on the transformer.

5. Electricity meter according to claims 2-4, in which the additional circuits comprise a radio module for wireless communication of electricity consumption data.

6. Electricity meter according to any of the preceding claims, in which the measuring circuits for each of the two or more phases measure current consumption by use of a shunt resistor.

7. Electricity meter according to any of the preceding claims, comprising two measuring circuits for measuring electric energy for each of two phases, and in which the transformer comprises two secondary windings for supplying the respective two measuring circuits.

8. Electricity meter according to any of the claims 1-6, comprising three measuring circuits for measuring electric energy for each of three phases, and in which the transformer comprises three secondary windings for supplying the respective three measuring circuits.

9. Electricity meter according to any of the preceding claims, in which the switch mode circuit uses a switch frequency of 10 kHz or more.

10. Electricity meter according to claim 9, in which the switch mode circuit uses a switch frequency of 100 kHz or more.

11. Electricity meter according to any of the preceding claims, in which the voltage supply is connected to two or more phases such that the switch mode circuit is supplied with voltage as long as there is voltage on one of the two or more phases.

12. Electricity meter according to any of the preceding claims, in which the transformer has a core and is designed with an air gap dimensioned such that a primary induction in the transformer with the core being mounted is less than 20 times the size of the corresponding primary induction for the transformer without the core being mounted.

13. Electricity meter according to claim 12, in which the core of the transformer is a ferrite core.

## Patentansprüche

1. Stromzähler zum Messen von Stromverbrauch in einem Stromversorgungsnetz mit einer oder mehreren Phasen (L1, L2, L3), wobei der Stromzähler Folgendes umfasst:
- eine Messschaltung für jede der einen oder mehreren Phasen zum Messen von elektrischer Energie für jede Phase,
- eine Spannungsversorgung, die von dem Stromversorgungsnetz mit Strom versorgt wird, die Spannungsversorgung Folgendes umfassend:
- eine Schaltschaltung, und
- einen Transformator (T) mit einer Primärwicklung, die an den Ausgang der Schaltschaltung angeschlossen ist, wobei der Transformator separate, galvanisch getrennte Sekundärwicklungen zur Spannungsversorgung der entsprechenden separaten Messschaltungen für jede Phase umfasst,
**dadurch gekennzeichnet, dass** der Transformator mit Spannung von der Schaltschaltung, die mit einer Schaltfrequenz arbeitet, die wesentlich höher als die des Stromversorgungsnetzes ist, versorgt wird, sodass die Spannungsversorgung ausreichend Leistung bereitstellen kann, um die Mess- und Berechnungsschaltungen ohne einen Kern im Transformator anzutreiben.

2. Stromzähler nach Anspruch 1, wobei der Transformator ferner zumindest eine separate, galvanisch getrennt Sekundärwicklung zur Spannungsversorgung von zusätzlichen Schaltungen in Bezug auf den Stromzähler umfasst.

3. Stromzähler nach Anspruch 2, wobei die zusätzlichen Schaltungen eine Berechnungsschaltung zum Empfangen von Energieverbrauchsdaten für jede der separaten Messschaltungen und zum Berechnen eines Gesamtenergieverbrauchs als eine Summe davon umfassen.

4. Stromzähler nach Anspruch 3, wobei die Schaltschaltung über Rückkopplung für die Spannung von der zumindest einen separaten Sekundärwicklung zur Spannungsversorgung der Berechnungsschaltung verfügt, und wobei die Schaltschaltung diese Rückkopplung für die Regulierung von Energieversorgung für die Primärwicklung am Transformator verwendet.

5. Stromzähler nach den Ansprüchen 2-4, wobei die zusätzlichen Schaltungen ein Funkmodul zur drahtlosen Kommunikation von Stromverbrauchsdaten umfassen.

6. Stromzähler nach einem der vorstehenden Ansprüche, wobei die Messschaltungen für jede der zwei oder mehr Phasen einen Stromverbrauch durch die Verwendung eines Nebenschlusswiderstands messen.

7. Stromzähler nach einem der vorstehenden Ansprüche, umfassend zwei Messschaltungen zum Messen von elektrischer Energie für jede der zwei Phasen, und wobei der Transformator zwei Sekundärwicklungen zum Versorgen der entsprechenden zwei Messschaltungen umfasst.

8. Stromzähler nach einem der Ansprüche 1-6, umfassend drei Messschaltungen zum Messen von elektrischer Energie für jede der drei Phasen, und wobei der Transformator drei Sekundärwicklungen zum Versorgen der entsprechenden drei Messschaltungen umfasst.

9. Stromzähler nach einem der vorstehenden Ansprüche, wobei die Schaltschaltung eine Schaltfrequenz von 10 kHz oder mehr verwendet.

10. Stromzähler nach Anspruch 9, wobei die Schaltschaltung eine Schaltfrequenz von 100 kHz oder mehr verwendet.

11. Stromzähler nach einem der vorstehenden Ansprüche, wobei die Spannungsversorgung an zwei oder mehr Phasen angeschlossen ist, sodass die Schaltschaltung so lange mit Spannung versorgt wird, wie Spannung an den zwei oder mehr Phasen anliegt.

12. Stromzähler nach einem der vorstehenden Ansprüche, wobei der Transformator einen Kern hat und mit einem Luftspalt ausgeführt ist, der so dimensioniert ist, dass eine Primärinduktion in dem Transformator mit dem eingesetzten Kern kleiner als das 20-fache der Größe der entsprechenden Primärinduktion für den Transformator ohne den eingesetzten Kern ist.

13. Stromzähler nach Anspruch 12, wobei der Kern des Transformators ein Ferritkern ist.

## Revendications

1. Compteur électrique permettant de mesurer la consommation d'énergie électrique dans un réseau d'alimentation électrique comprenant une ou plusieurs phases (L1,L2,L3), dans lequel le compteur électrique comprend :
- un circuit de mesure pour chacune de la ou plusieurs phases pour la mesure de l'énergie électrique de chaque phase,
- une tension d'alimentation étant fournie avec de l'électricité provenant d'un réseau d'alimentation électrique, la tension d'alimentation comprenant
- un circuit à mode de commutation, et
- un transformateur (T) dont l'enroulement principal est connecté à la sortie du circuit à mode de commutation, le transformateur comprenant des enroulements secondaires distincts séparés par galvanisation pour l'alimentation des circuits de mesure séparés respectifs pour chaque phase,
**caractérisé en ce que** le transformateur est alimenté par la tension provenant du circuit à mode de commutation fonctionnant avec une fréquence de commutation sensiblement supérieure à celle du réseau d'alimentation électrique, de sorte que la tension d'alimentation puisse fournir une alimentation suffisante pour alimenter les circuits de mesure et de calcul sans noyau dans le transformateur.

2. Compteur électrique selon la revendication 1, le transformateur comprenant en outre au moins un enroulement secondaire distinct séparé par galvanisation pour l'alimentation électrique des circuits additionnels relativement au compteur d'électricité.

3. Compteur électrique selon la revendication 2, les circuits additionnels comprenant un circuit de calcul pour recevoir des données de consommation d'énergie pour chacun des circuits de mesure distincts, et pour le calcul d'une consommation d'énergie totale en tant que somme de ces derniers.

4. Compteur électrique selon la revendication 3, dans lequel le circuit à mode de commutation reçoit des informations en retour sur la tension de l'au moins un enroulement secondaire séparé pour l'alimentation électrique du circuit de calcul, et dans lequel le circuit à mode de commutation utilise ces informations en retour pour la régulation de la fourniture d'énergie à l'enroulement principal sur le transformateur.

5. Compteur électrique selon les revendications 2 à 4, les circuits additionnels comprenant un module radio pour les communications sans fil des données sur la consommation d'électricité.

6. Compteur électrique selon une quelconque des revendications précédentes, dans lequel les circuits de mesure pour chacune des deux ou plusieurs phases mesurent le courant consommé à l'aide d'une résistance en dérivation.

7. Compteur électrique selon une quelconque des revendications précédentes, comprenant deux circuits de mesure pour mesurer l'énergie électrique pour chacune des deux phases, et dans lequel le transformateur comprend deux enroulements secondaires pour l'alimentation des deux circuits de mesure respectifs.

8. Compteur électrique selon une quelconque des revendications 1 à 6, comprenant trois circuits de mesure pour mesurer l'énergie électrique pour chacune des trois phases, et dans lequel le transformateur comprend deux enroulements secondaires pour l'alimentation des trois circuits de mesure respectifs.

9. Compteur électrique selon une quelconque des revendications précédentes, dans lequel le circuit à mode de commutation utilise une fréquence de commutation de 10 kHz ou davantage.

10. Compteur électrique selon la revendication 9, dans lequel le circuit à mode de commutation utilise une fréquence de commutation de 100 kHz ou davantage.

11. Compteur électrique selon une quelconque des revendications précédentes, dans lequel la tension d'alimentation est connectée à deux ou plusieurs phases de sorte que le circuit à mode de commutation soit alimenté par une tension tant qu'il y a une tension sur une des deux ou plusieurs phases.

12. Compteur électrique selon une quelconque des revendications précédentes, dans lequel le transformateur possède un noyau et est conçu avec un entrefer dimensionné de sorte qu'une induction principale dans le transformateur avec le noyau monté est inférieure à 20 fois la taille de l'induction principale correspondante pour le transformateur sans le noyau étant monté.

13. Compteur électrique selon la revendication 12, le noyau du transformateur étant un noyau de ferrite.
